# EUROPEAN PATENT APPLICATION

(11) **EP 3 506 506 A1**
(43) Date of publication of application: **03.07.2019**
(21) Application number: 18213755.4
(22) Date of filing: 18.12.2018
(51) Int. Cl.: H03K 17/082

(54) **PROTECTION CIRCUIT AND METHOD FOR CONTROLLABLE SWITCH**

(30) Priority: 02.01.2018 CN 201810002039
(71) Applicant: General Electric Company, Schenectady, NY 12345 (US)
(72) Inventor: Yu, Hao, ShangHai, Shanghai 201203 (CN); Zhang, Fan, ShangHai, Shanghai 201203 (CN); Yuan, Zhihui, 85748 Bavaria (DE); Liu, Jiao, ShangHai, Shanghai 201203 (CN); Schroeder, Stefan, 85748 Bavaria (DE)
(74) Representative: Rüger Abel

(57) **Abstract**

A protection circuit for a controllable switch comprising a control terminal, a first terminal, and a second terminal having a lower electric potential than the first terminal, the protection device comprising: an active clamping module, coupled between the first terminal and the control terminal of the controllable switch, configured to clamp a first voltage across the first terminal and the second terminal; and a damping module, coupled to an output of the active clamping module and configured to damp oscillations of a second voltage across the control terminal and the second terminal. Embodiments of the present disclosure also relate to a protection method for a controllable switch.

## Description

### BACKGROUND

Embodiments of the present disclosure relate generally to protection circuits and methods for controllable switches.

Controllable switches, such as insulated gate bipolar transistor (IGBT) and metal-oxide-semiconductor field-effect transistor (MOSFET) often encounter over voltage events at various working scenarios. The active voltage clamping (AVC) circuit is developed to solve this problem, which works as a close loop control system for the voltage across the controllable switch. However, in practice, the delay effect due to the characteristics of the controllable switch will have a negative impact on the close loop stability, which will cause unacceptable oscillations of the voltage.

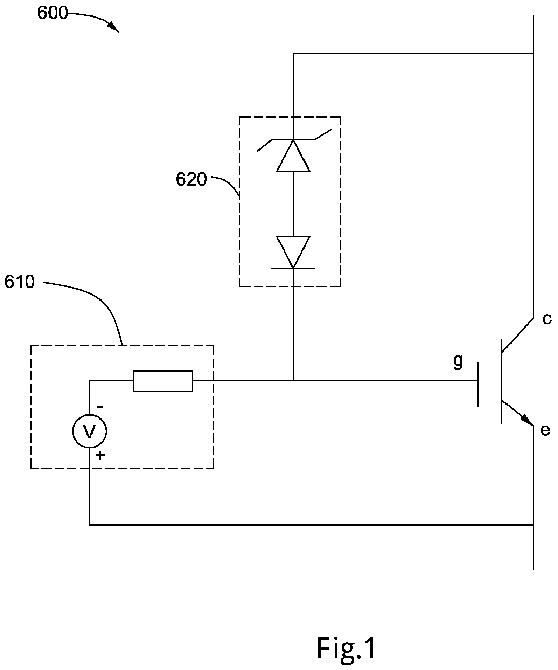

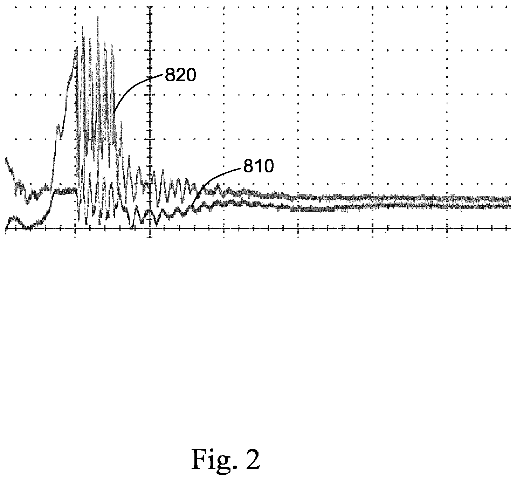

Fig. 1 shows a conventional protection circuit 600 for a IGBT. The protection circuit 600 comprises an AVC circuit 620 and a gate driver 610. The AVC circuit 620 is coupled between a collector and a gate of the IGBT and configured to clamp a first voltage (Vce) across the collector and the emitter. The gate driver 610 is coupled between a gate and the emitter of the IGBT. Fig. 2 shows a waveform 810 of the first voltage (Vce) and a waveform 820 of a second voltage (Vge) during the switching off of the IGBT. Referring to Fig. 2, the waveforms of the first and second voltage 810, 820 both oscillate severely, which may damage the IGBT.

Therefore, it is desirable to provide new protection circuits and methods for controllable switches to solve the above-mentioned problem.

### BRIEF DESCRIPTION

In one aspect, embodiments of the present disclosure relate to a protection circuit for a controllable switch which comprises a control terminal, a first terminal, and a second terminal having a lower electric potential than the first terminal. The protection device comprises an active clamping module and a damping module. The active clamping module is coupled between the first terminal and the control terminal of the controllable switch and configured to clamp a first voltage across the first terminal and the second terminal. The damping module is coupled to an output of the active clamping module and configured to damp oscillations of a second voltage across the control terminal and the second terminal.

In another aspect, embodiments of the present disclosure relate to a protection method for a controllable switch which comprises a control terminal, a first terminal, and a second terminal having a lower electric potential than the first terminal. The protection method comprises clamping a first voltage across the first terminal and the second terminal by an active clamping module coupled between the first terminal and the control terminal of the controllable switch; and damping oscillation of a second voltage across the control terminal and the second terminal by a damping module coupled to an output of the active clamping module.

### DRAWINGS

These and other features, aspects, and advantages of the present disclosure will become better understood when the following detailed description is read with reference to the accompanying drawings in which like characters represent like parts throughout the drawings, wherein:
Fig. 1 is a sketch view of a conventional protection circuit;
Fig. 2 is a sketch view illustrating waveforms of a first and second voltage during switching off of a controllable switch which is protected by the protection circuit shown in Fig. 1;
Fig. 3 is a sketch view of a protection circuit in accordance with an exemplary embodiment of the present disclosure;
Fig. 4 is a sketch view of a protection circuit in accordance with another exemplary embodiment of the present disclosure;
Fig. 5 is a sketch view illustrating waveforms of a first and second voltage during switching-off of a controllable switch which is protected by the protection circuit shown in Fig. 4;
Fig. 6 is a sketch view of a protection circuit in accordance with another exemplary embodiment of the present disclosure;
Fig. 7 is a sketch view of a protection circuit in accordance with another exemplary embodiment of the present disclosure; and
Fig. 8 is a sketch view of a protection circuit in accordance with another exemplary embodiment of the present disclosure.

### DETAILED DESCRIPTION

In an effort to provide a concise description of these embodiments, not all features of an actual implementation are described in one or more specific embodiments. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of the present disclosure.

Unless defined otherwise, technical and scientific terms used herein have the same meaning as is commonly understood by one of ordinary skill in the art to which the present disclosure belongs. The terms "first," "second," "third," "fourth," and the like, as used herein do not denote any order, quantity, or importance, but rather are used to distinguish one element from another. Also, the terms "a" and "an" do not denote a limitation of quantity, but rather denote the presence of at least one of the referenced items. The term "or" is meant to be inclusive and mean either any, several, or all of the listed items. The use of "including," "comprising," or "having," and variations thereof herein are meant to encompass the items listed thereafter and equivalents thereof as well as additional items.

Embodiments of the present disclosure relate to a protection circuit for a controllable switch, which can protect the controllable switch from over voltage and obtain good clamping behavior.

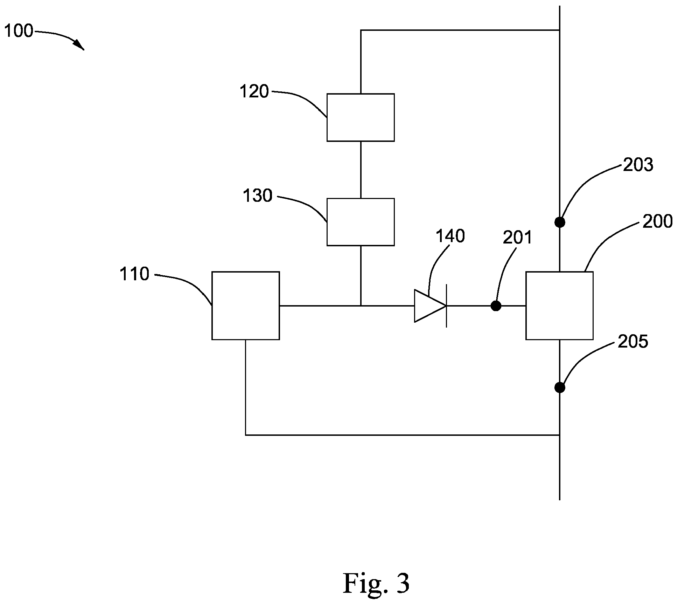

Fig. 3 shows a sketch view of a protection circuit 100 in accordance with an exemplary embodiment of the present disclosure. The protection circuit 100 is coupled with a controllable switch 200 and configured to protect the controllable switch 200. The controllable switch 200 comprises a control terminal 201, a first terminal 203, and a second terminal 205, wherein the second terminal 205 has a lower electric potential than the first terminal 203.

The controllable switch 200 may comprise at least one of an insulated gate bipolar transistor (IGBT) and a metal-oxide-semiconductor field effect transistor (MOSFET). In some embodiments, the controllable switch 200 comprises an IGBT, and the control terminal 201, the first terminal 203 and the second terminal 205 are respectively a gate, a collector and an emitter of the IGBT. In some other embodiments, the controllable switch 200 comprises a MOSFET, the control terminal 201, the first terminal 203 and the second terminal 205 are respectively a gate, a drain and a source of the MOSFET.

Referring to Fig. 3, the protection circuit 100 comprises a gate driver 110, an active clamping module 120, a damping module 130 and a diode 140.

The gate driver 110 is coupled to the control terminal 201 of the controllable switch 200 and configured to drive the controllable switch 200 by sending control signals to the control terminal 201.

The active clamping module 120 is coupled between the first terminal 203 and the control terminal 201 of the controllable switch 200 and configured to clamp a first voltage across the first terminal 203 and the second terminal 205. In some embodiments, the active clamping module 120 comprises at least one transient voltage suppressor (TVS).

The damping module 130 is coupled to an output of the active clamping module 120 and configured to damp oscillations of a second voltage across the control terminal 201 and the second terminal 205. In some embodiments, the damping module 130 comprises a filter, such as a band-pass filter or a low pass filter.

The diode 140 is coupled between the output of the damping module and the control terminal 201 of the controllable switch 200, and configured to allow a current flowing from the damping module 130 to the control terminal 201 and prevent a current flowing from the control terminal 201 to the damping module 130. In one embodiment, the diode 140 has a cathode coupled to the control terminal 201 of the controllable switch 200 and an anode coupled to the output of the damping module 130.

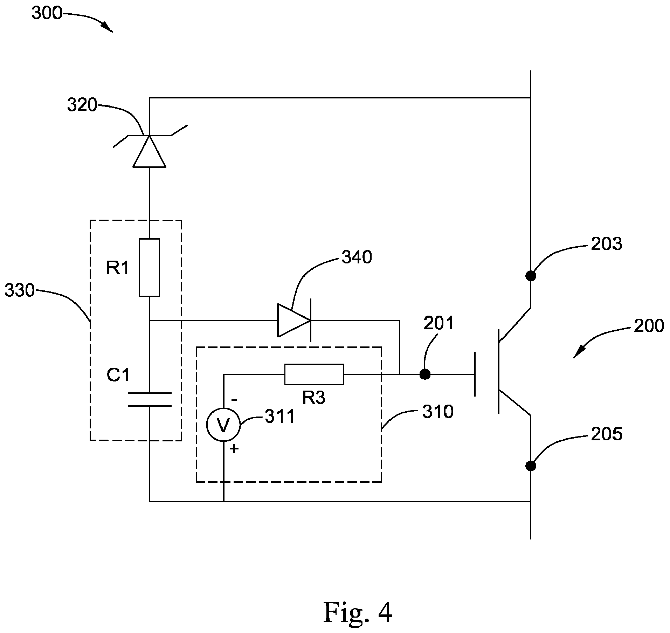

Fig. 4 is a sketch view showing a protection circuit 300 in accordance with another exemplary embodiment of the present disclosure. The protection circuit 300 comprises a gate driver 310, an active clamping module 320, a damping module 330 and a diode 340.

The gate driver 310 is coupled between the control terminal 201 and the second terminal 205 and comprises a voltage source 311 and a gate off resistor R3 which is coupled with the voltage source 311 in series.

The active clamping module 320 coupled between the first terminal 203 and the control terminal 201 comprises a transient voltage suppressor (TVS) or a Zener diode, which has a cathode coupled with the first terminal 203 of the controllable switch 200 and an anode coupled with an input of the damping module 330. The active clamping module 320 is configured to clamp a first voltage across the first terminal 203 and the second terminal 205.

The damping module comprises a low pass filter 330 and is configured to block highfrequency signals from the active clamping module 320, in order to damp oscillations of a second voltage across the control terminal 201 and the second terminal 205. Specifically, the low pass filter 330 comprises a first resistor R1 and a first capacitor C1. The first resistor R1 is coupled between the first terminal 203 and the control terminal 201 of the controllable switch 200, and in series with the active clamping module 320. The first capacitor C1 is coupled between the control terminal 201 and the second terminal 205 of the controllable switch 200.

In the embodiment shown in Fig. 4, the first resistor R1 has a first terminal coupled with the anode of the TVS 320 and a second terminal coupled with the control terminal via the diode 340. The first capacitor C1 has a first terminal coupled with the second terminal of the first resistor R1 and a second terminal coupled with the second terminal 205 of the controllable switch. The diode 340 has an anode coupled with a node between the first resistor R1 and the first capacitor C1, and a cathode coupled with the control terminal 201 of the controllable switch 200.

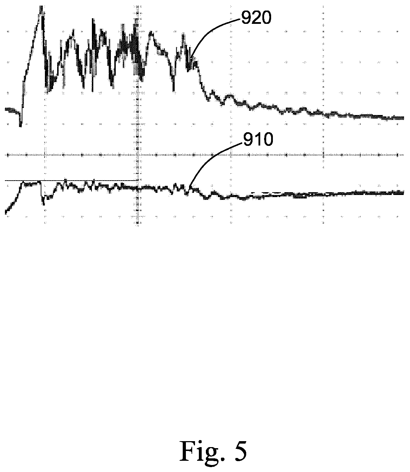

Fig. 5 is a sketch view illustrating a waveform 910 of the first voltage and a waveform 920 of the second voltage during the switching off of a controllable switch which is protected by the protection circuit shown in Fig. 4. Referring to Fig. 5, the waveform of the second voltage 920 oscillates at first, but then tends to be stable. The waveform of the first voltage 910 is substantially stable during the switching off the controllable switch. Compared to the waveforms in Fig. 2, the damping module reduces the oscillations and thus reduced risk of damage of the controllable switch.

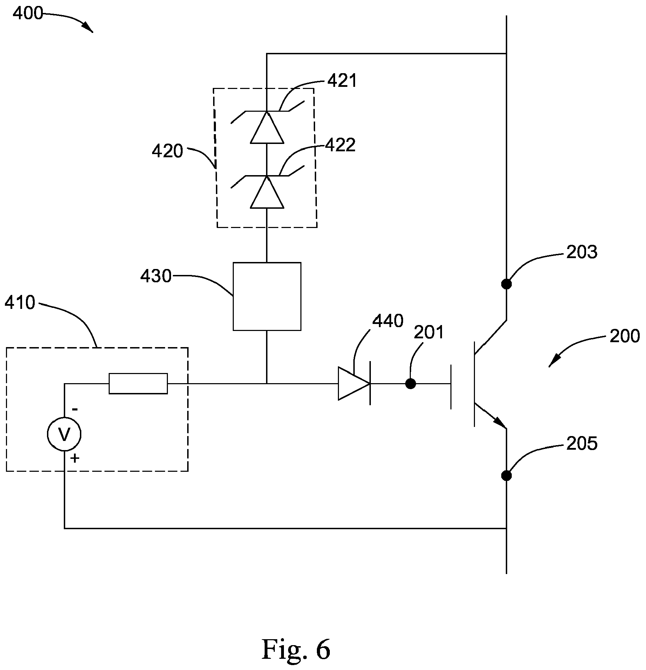

Fig. 6 is a sketch view showing a protection circuit 400 in accordance with another exemplary embodiment of the present disclosure. The protection circuit 400 comprises a gate driver 410, an active clamping module 420, a damping module 430 and a diode 440.

The active clamping module 420 comprises a plurality of TVSs coupled in series between the first terminal 203 and the control terminal 201 of the controllable switch 200, and each TVS has a breakdown voltage. The active clamping module 420 provides a higher clamping threshold than the active clamping module with a single TVS, such as the active clamping module 320 shown in Fig. 4, because the clamping threshold of the active clamping module 420 is equal to a sum of the breakdown voltages of all the TVSs. When the first voltage exceeds the clamping threshold, the plurality of TVSs start to work at the same time to clamp the first voltage.

The gate driver 410, the damping module 430 and the diode 440 may be similar to the corresponding components of the protection circuit 100 and 300, description of which will not be repeated here.

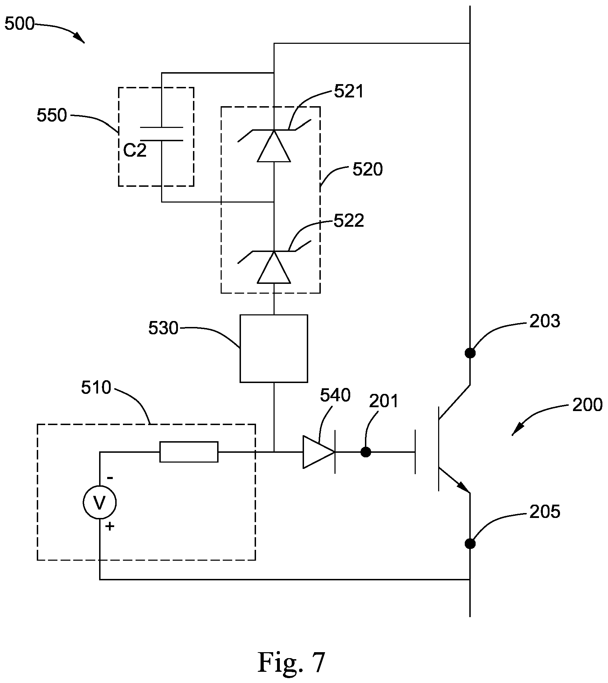

Fig. 7 is a sketch view showing a protection circuit 500 in accordance with another exemplary embodiment of the present disclosure. The protection circuit 500 comprises a gate driver 510, an active clamping module 520, a damping module 530, a diode 540 and a bypass module 550.

The active clamping module 520 comprises a plurality of TVSs coupled in series between the first terminal 203 and the control terminal 201 of the controllable switch 200.

The bypass module 550 is coupled in parallel with at least one of the plurality of TVSs, and configured to bypass the at least one of the plurality of TVSs (hereinafter referred to as a first part of TVSs) when a rising rate of the first voltage exceeds a pre-determined bypass threshold, in such a manner that the other TVS(s) not being bypassed (hereinafter referred to as a second part of TVSs) will start to work at first once the first voltage exceeds a first clamping threshold equal to a sum of breakdown voltages of the second part of TVSs, which is lower than a second clamping threshold (a sum of breakdown voltages of all TVSs) when all the TVSs are engaged. After the second part of TVSs start to clamp the first voltage, the rising rate of the first voltage will decrease because of the clamping. Subsequently, the bypass module 550 will not bypass the first part of TVSs anymore, and the first part of TVSs will start to work with the second part of TVSs together.

In the embodiment shown in Fig. 6, no bypass module is coupled with the active clamping module 420 and thus all the TVSs start to work simultaneously when the first voltage exceeds the clamping threshold (the sum of the breakdown voltages of all TVSs). However, in the embodiment shown in Fig. 7, a part (the second part) of the TVSs in the active clamping module 520 starts to work before the first voltage exceeds that clamping threshold (the sum of the breakdown voltages of all TVSs). Therefore, the active clamping module 520 will start up earlier than the active clamping module 420 in Fig. 6, so the startup of the active clamping module 520 is speeded up by using the bypass module 550.

In the embodiment shown in Fig. 7, the active clamping module 520 comprises a first TVS 521 and a second TVS 522. The bypass module 550 is coupled in parallel with the first TVS 521, and the bypass module 550 comprises a second capacitor C2. The bypass threshold depends on a parameter of the second capacitor C2. When the first voltage increases in a rising rate higher than the bypass threshold, the first TVS 521 will be bypassed by the bypass module 550, and the second TVS 522 will clamp the first voltage when the first voltage increases to a breakdown voltage of the second TVS 522. Then, the rising rate of the first voltage decreases, and the first TVS 521 will start to work.

The gate driver 510, the damping module 530 and the diode 540 may be similar to the corresponding components of the protection circuit 100 and 300, description of which will not be repeated here.

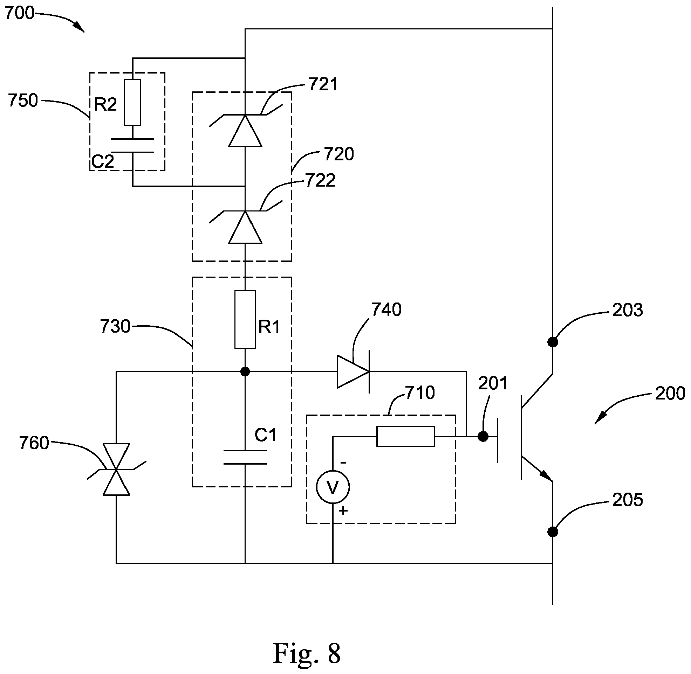

Fig. 8 is a sketch view showing a protection circuit 700 in accordance with another exemplary embodiment of the present disclosure. The protection circuit 700 comprises a gate driver 710, an active clamping module 720 comprising two TVSs 721, 722, a damping module 730, a diode 740, a bypass module 750 and a voltage limiter 760.

The gate driver 710, the active clamping module 720, the damping module 730 and the diode 740 may be similar to the corresponding components of the protection circuit 500, description of which will not be repeated here.

The bypass module 750 comprises a second capacitor C2 and a second resistor R2 coupled in series with the second capacitor C2. The second capacitor C2 is configured to bypass a part of TVSs in the active clamping module 720, when a rising rate of the first voltage exceeds a pre-determined bypass threshold. The second resistor R2 is configured to limit a current flowing through the second capacitor C2 and the second resistor R2.

The voltage limiter 760 is coupled between the control terminal 201 and the second terminal 205 of the controllable switch 200 and configured to limit a second voltage across the control terminal 201 and the second terminal 205 in a preset range. When the second voltage increases to a value exceeding the preset range, the voltage limiter 760 start to work to clamp the second voltage.

In some embodiments, the voltage limiter comprises a bilateral Zener diode 760 coupled between the control terminal 201 and the second terminal 205 of the controllable switch 200. The bilateral Zener diode 760 is configured to reset the second capacitor C2 of the bypass module 750 during the switching on of the controllable switch.

When the controllable switch is working, it is turned on and off alternately for many times. During the switching off period, the second resistor R2 may be charged to bypass the TVS(s), and then when the controllable switch is turned on, the second capacitor C2 will be discharged in order to be reset before a next switching off period. The second capacitor C2 is discharged via the second resistor R2, the controllable switch 200, the bilateral Zener diode 760, the first resistance R1, and the TVS 722. After the discharging is finished, a voltage across the second capacitor C2 is reset to an initial value, and the initial value depends on a breakdown voltage of the bilateral Zener diode 760 which is a fixed value. Therefore, the voltage across the second capacitor C2 will be the same every time after the discharging and before the next switching off period, which will help to enable consistent behavior of the bypass module.

Embodiments of the present disclosure also relate to a protection method for a controllable switch, the controllable switch comprising a control terminal, a first terminal, and a second terminal having a lower electric potential than the first terminal.

The method comprises clamping a first voltage across the first terminal and the second terminal by an active clamping module coupled between the first terminal and the control terminal of the controllable switch; and damping oscillations of a second voltage across the control terminal and the second terminal by a damping module coupled to an output of the active clamping module.

As will be understood by those familiar with the art, the present disclosure may be embodied in other specific forms without depending from the spirit or essential characteristics thereof. Accordingly, the disclosures and descriptions herein are intended to be illustrative, but not limiting, of the scope of the disclosure which is set forth in the following claims.

## Claims

1. A protection circuit for a controllable switch comprising a control terminal, a first terminal, and a second terminal having a lower electric potential than the first terminal, the protection circuit comprising:
an active clamping module, coupled between the first terminal and the control terminal of the controllable switch, configured to clamp a first voltage across the first terminal and the second terminal; and
a damping module, coupled to an output of the active clamping module and configured to damp oscillations of a second voltage across the control terminal and the second terminal.

2. The circuit according to claim 1, wherein the damping module comprises a filter.

3. The circuit according to claim 2, wherein the filter comprises a band-pass filter.

4. The circuit according to claim 2, wherein the filter comprises a low pass filter, the low pass filter comprising:
a first resistor coupled between the first terminal and the control terminal of the controllable switch, and in series with the active clamping module; and
a first capacitor coupled between the control terminal and the second terminal of the controllable switch.

5. The circuit according to claim 1, wherein the active clamping module comprises at least one transient voltage suppressor (TVS).

6. The circuit according to claim 1, wherein the active clamping module comprises a plurality of TVSs coupled in series between the first terminal and the control terminal of the controllable switch.

7. The circuit according to claim 6, further comprising a bypass module coupled in parallel with at least one of the plurality of TVSs, and configured to bypass the at least one of the plurality of TVSs when a rising rate of the first voltage exceeds a pre-determined bypass threshold.

8. The circuit according to claim 7, wherein the bypass module comprises a second capacitor.

9. The circuit according to claim 1, further comprising a voltage limiter coupled between the control terminal and the second terminal of the controllable switch.

10. The circuit according to claim 9, wherein the voltage limiter comprises a bilateral Zener diode.

11. The circuit according to claim 1, wherein the controllable switch comprises at least one of an insulated gate bipolar transistor and a metal-oxide-semiconductor field effect transistor.

12. The circuit according to claim 1, further comprising a diode having a cathode coupled to the control terminal of the controllable switch and an anode coupled to an output of the damping module.

13. The circuit according to claim 1, further comprising: a gate driver, coupled to the control terminal of the controllable switch and configured to drive the controllable switch.

14. A protection method for a controllable switch comprising a control terminal, a first terminal, and a second terminal having a lower electric potential than the first terminal, the protection method comprising:
clamping a first voltage across the first terminal and the second terminal by an active clamping module coupled between the first terminal and the control terminal of the controllable switch; and
damping oscillation of a second voltage across the control terminal and the second terminal by a damping module coupled to an output of the active clamping module.
